# EUROPEAN PATENT APPLICATION

(11) **EP 4 481 817 A1**
(43) Date of publication of application: **25.12.2024**
(21) Application number: 23753260.1
(22) Date of filing: 14.02.2023
(51) Int. Cl.: H01L 25/16, H01L 23/538

(54) **SENSOR AND TOF CAMERA USING SAME**

(30) Priority: 14.02.2022 KR 20220018846
(71) Applicant: Lipac Co., Ltd., Seoul 07281 (KR)
(72) Inventor: CHOI, Seong Wook, Seoul 07281 (KR)
(74) Representative: Lambacher, Michael
(86) International application number: PCT/KR2023/002139
(87) International publication number: WO 2023/153914

(57) **Abstract**

Provided are a time of flight (ToF) sensor and a ToF camera using same, the sensor enabling a light emitting unit and a light receiving unit to be packaged into one or two system-in-packages (SIP) at a wafer level by using semiconductor packaging according to fan-out wafer level package (FOWLP), thereby implementing an ultra-thin package. The ToF camera includes: a light emitting unit emitting light to an object; a light receiving unit for receiving reflected light reflected from the object and sensing same; a lens unit for controlling the path of the light so that the light is emitted at the object and the reflected light reflected from the object is received by the light receiving unit; and a control unit having a controller printed circuit board (PCB), which has the light emitting unit and the light receiving unit mounted on the bottom surface thereof and has the lens unit mounted on the top surface thereof.

## Description

### TECHNICAL FIELD

The present invention relates to a sensor, and more specifically, to a sensor and a time of flight (ToF) camera using same, the sensor enabling a light emitting unit and a light receiving unit to be packaged into one or two system-in-packages (SIP) at a wafer level by using semiconductor packaging according to fan-out wafer level packaging (FOWLP), thereby implementing an ultra-thin package.

### BACKGROUND ART

In order to provide a quadcopter, an autonomous driving of a vehicle, a motion recognition control, a virtual reality, an augmented reality, a three-dimensional (3D) game, a robot control, and a three-dimensional image having a sense of depth, technologies such as three-dimensional (3D) camera, a motion sensor, a laser radar, and the like, capable of obtaining distance information by measuring a distance from an object are being developed.

In order to obtain 3D content, depth map, that is, distance information between an object and a camera is required, and the depth map indicates perspective information of another point for one point of a two-dimensional (2D) image.

Depth information (distance information between an object and a camera) of an object may be obtained by using a stereo vision method using two cameras or a triangulation method using structured light. These schemes have a disadvantage in that the accuracy of depth information decreases as the distance between the object and the camera increases.

Meanwhile, a 3D imaging apparatus to which a ToF sensor is applied may emit light to an object and calculate a distance to the object by using light returned after being reflected. Specifically, the ToF sensor may calculate the distance to the object using the time difference until the irradiated light returns from the object and the speed of the light.

Since the ToF sensor directly irradiates light, a depth value may be measured in all pixels, and a depth image may be acquired in real time. The ToF sensor is capable of high-speed operation, has less noise due to illumination change compared to the stereo vision method, and may reduce the amount of computation of a post-processing algorithm.

The ToF camera may be configured to measure the distance to an object using near-infrared rays, ultrasonic waves, and lasers, and may be configured as an infrared (IR) light and a ToF sensor.

In this case, in the related art, the IR camera and the ToF sensor may be separately manufactured and used in combination with one housing, or may be stacked in a vertical direction in one package.

When the IR light and the ToF sensor are separately manufactured and combined into one housing, there is a problem in that a large area is generally occupied.

In addition, when the IR light and the ToF sensor are stacked in the vertical direction together with a controller PCB and implemented as a single package, there is a problem in that the height from the imaging surface of the ToF sensor to the bottom is increased to fail to have a slim structure.

Further, when the IR light and the ToF sensor are vertically stacked together with the controller PCB and implemented into one package, the controller PCB has a stacked structure in which a light emitting device and a ToF sensor are mounted on the controller PCB.

The light emitting device may be wire-bonded to the upper portion of the controller PCB, but in this case, heat dissipation should be performed through the controller PCB, and thus heat dissipation performance may be deteriorated. In addition, when the ToF sensor is mounted under the controller PCB, since the ToF sensor is arranged close to the lower portion of the controller PCB, a through hole of the controller PCB has a problem in which a light emitting unit of a light emitting device may be hidden due to a hole tolerance.

In addition, in the related art, the controller PCB may use only one of the upper surface and the lower surface thereof, and thus it is difficult to reduce the area of the controller PCB.

Further, in the related art, there is a problem in that a plurality of optical lenses for diffusing and irradiating light from a light emitting unit to an object when transmitting an optical signal are provided.

Meanwhile, semiconductor chips may be used to manufacture light receiving devices capable of reacting to light or light emitting devices emitting light, as well as serving as a logic or driving IC. Further, applications of these optical devices may be used in a proximity sensor, a time of flight (ToF) sensor, a light detection and ranging (LIDAR) device, and the like, which include a light emitting device.

Optical devices should be used together with electronic devices that drive or interface the optical devices, thereby converting optical signals into electronic signals. For example, in the field of transmitting optical data, an optical device and an electronic device may be used together for a module for converting an optical signal into a digital signal.

As another example, in the optical sensor field, a device for converting characteristics of received light into image data or depth data may be used together with an optical device.

In all of the above conventional applications, a plurality of chips are mounted using a printed circuit board (PCB) in which a wiring pattern is mostly manufactured and connected by wire-bonding. This is a chip-on-board (CoB) type package.

In addition, instead of a package using a PCB, an optical/electrical device may be packaged at a wafer level using a semiconductor package method based on a fan-out wafer level package (FOWLP) process, which is a technology that may increase performance by using a high-precision redistribution layer (RDL) while producing an ultra-thin package.

However, when the electrical/optical package is performed using the semiconductor package, most of optical paths may be perpendicular to light emitting device chips, so that the optical paths may be arranged on one surface of the package, and a terminal pad for electrical connection with the outside may be formed on the opposite surface of the package. In addition, the redistribution layer for connecting between chips molded therein is arranged on one surface of the electrical/optical package having the optical path.

### DISCLOSURE

### TECHNICAL PROBLEM

The present invention has been made to solve the above problems, and it is an objective of the present invention to provide a sensor and a ToF camera using same, the sensor being capable of implementing an ultra-thin package by packaging a light emitting unit and a light receiving unit at a wafer level using one or two system-in-packages (SIP) by using semiconductor packaging according to fan-out wafer level packaging (FOWLP), instead of a package using a printed circuit board (PCB) of a thick layer.

It is another objective of the present invention to provide a sensor having a system-in-package (SIP) and a ToF camera using same, the sensor capable of minimizing a height from a sensor imaging surface of a light receiving unit to a bottom of a floor.

It is another objective of the present invention to provide a sensor and a ToF camera using same, wherein the sensor does not cover a light entrance/exit part of a light source (a vertical-cavity surface-emitting laser (VCSEL) source) of a light emitting unit due to a hole tolerance of a controller PCB even when a SIP for a light emitting unit is mounted at a rear side of a controller PCB, like a ToF sensor for a light receiving unit.

It is another objective of the present invention to provide a sensor and a ToF camera using same, in which a light source (e.g., VCSEL) of a light emitting unit and a light driving IC are integrated into a system-in-package (SIP) for a light emitting unit to reduce inductance between the light source (e.g., VCSEL) and the light driving IC, thereby increasing the resolution of the ToF sensor by a gain of rise/fall time when light in the form of a square wave (pulse) is generated.

It is another objective of the present invention to provide a sensor and a ToF camera, the sensor being capable of effective heat dissipation through a housing of a main body in which a light emitting unit and a light receiving unit implemented in a system-in-package (SIP) form are mounted on a lower portion of a controller PCB, so that heat dissipation of the light emitting unit and the light receiving unit may be effectively dissipated through the housing of the main body made of metal without being disturbed by the controller PCB.

It is another objective of the present invention to provide a sensor and a ToF camera using same, the sensor being capable of safely protecting a sensing area of the sensor by a primary sealing of the sensing area of the sensor by a filter and a secondary sealing of an outer circumference of the sensor in contact with a controller PCB.

### TECHNICAL SOLUTION

According to an aspect of the present invention, there is provided a time of flight (ToF) camera including: a light emitting unit emitting light to an object; a light receiving unit receiving and sensing reflected light reflected from the object; a lens unit controlling a path of the light so that the light is emitted to the object and the reflected light reflected from the object is received by the light receiving unit; and a control unit having a controller printed circuit board (PCB), which has the light emitting unit and the light receiving unit mounted on the bottom surface thereof and has the lens unit mounted on the top surface thereof.

The light emitting unit and the light receiving unit may be formed in a single or two optical system-in-packages (O-SIP) type, and may be mounted on a lower surface of the controller PCB in a flip-chip type.

The controller PCB may include a first light passing window through which light emitted from the light emitting unit passes and a second light passing window forming a reception path of the reflected light so that the reflected light is received by the light receiving unit.

Furthermore, the light emitting unit may include: a mold body having a first surface and a second surface, which are flat, in a lower portion and an upper portion of the mold body, respectively; a light emitting device molded inside the mold body to expose a bonding pad on the first surface; a light driving integrated circuit (IC) molded to be spaced apart from the light emitting device inside the mold body to expose a bonding pad on the first surface; and a redistribution layer (RDL) formed on the second surface of the mold body and having a plurality of fan-out terminal pads electrically connected to the outside while interconnecting the light emitting device and the light driving IC.

The ToF camera according to an embodiment of the present invention may further include first and second metal structures for heat dissipation in which upper surfaces of the first and second metal structures are bonded to lower portions of the light emitting device and the light driving IC and lower surfaces thereof are exposed, respectively.

In addition, the ToF camera according to an embodiment of the present invention may further include: a third metal structure for a via that is inserted through the mold body between the light emitting device and the light driving IC, has an upper end portion connected to the RDL and a lower end portion exposed; and a metal connection layer that connects the RDL to the lower portions of the light emitting device and the light driving IC and has a lower surface of the metal connection layer exposed by interconnecting the lower surfaces of the first to third metal structures.

The ToF camera according to an embodiment of the present invention may further include an optical lens formed on the redistribution layer and positioned above a light entrance/exit part of the light emitting device.

The lens unit includes a lens for the light emitting unit, a lens assembly for a light receiving unit, and a lens housing for accommodating the lens for the light emitting unit and the lens assembly for the light receiving unit therein, and the lens housing may include a partition unit for partitioning a first space in which the lens for the light emitting unit is accommodated and a second space in which the lens assembly for the light receiving unit is accommodated.

In this case, the lens for the light emitting unit includes a diffuser that spreads light so that the light emitting device itself may take a larger light emitting area than a light emitting area of the light emitting unit, and the optical lens may serve to collect light so that the light emitted from the light emitting device may enter an area of the diffuser.

The light receiving unit includes a filter that is placed on an optical path between the object and the sensor to pass light in a wavelength band of the optical signal output by the light emitting unit; and a sensor that senses the optical signal, outputs the sensed optical signal as an electrical signal, and senses light of a wavelength corresponding to the wavelength of light output from the light emitting device, wherein the filter may be placed in a light passing window formed on the controller PCB to receive the reflected light reflected from the object by the light receiving unit.

In addition, the sensor may include: a sensor chip, with a sensing area, which senses the optical signal and outputs the sensed optical signal as an electrical signal and senses light of a wavelength corresponding to the wavelength of light output from the light emitting device; a mold body having first and second surfaces which are flat on lower and upper portions, respectively, and surrounding the sensing area to expose the sensing area to the second surface; and a redistribution layer formed on the second surface of the mold body excluding the sensing area and in which a plurality of fan-out terminal pads for electrically connecting the sensor chip to the outside are arranged.

The filter may be positioned above the redistribution layer to seal the sensing area of the sensor, and an outer circumferential part of the sensor mounted under the controller PCB may be sealed.

In addition, the light emitting unit and the light receiving unit are formed in the form of an optical system-in-package (O-SIP), and the light emitting unit and the light receiving unit may further include a thermal interface material (TIM) installed under the package to form a heat dissipation path to a metal housing of a terminal body.

The light emitting unit and the light receiving unit are formed in the form of a single O-SIP, and the single O-SIP may include: a mold body having a first surface and a second surface which are flat on a lower portion and an upper portion of the mold body, respectively; a light emitting device molded inside the mold body to expose a bonding pad on the second surface; a light driving IC molded to be spaced apart from the light emitting device inside the mold body to expose the bonding pad on the second surface; a sensor molded at a distance from the light driving IC inside the mold body to expose the sensing area that senses light on the second surface; and a redistribution layer formed on the second surface of the mold body with the exception of the sensing area and including a plurality of fan-out terminal pads for electrically connecting the sensor, light emitting device, and light driving IC to the outside while interconnecting the sensor, light emitting device, and light driving IC.

The sensor according to an embodiment of the present invention includes: a sensor that has a first surface and a second surface on lower and upper portions, respectively, to expose a sensing area that senses light on the second surface; and a redistribution layer formed on the second surface excluding the sensing area and in which a plurality of fan-out terminal pads for electrically connecting the sensor to the outside are arranged.

In addition, the sensor according to another embodiment of the present invention includes: a mold body having a first surface and a second surface which are flat on a lower portion and an upper portion of the mold body, respectively; a sensor molded inside the mold body to expose the sensing area that senses light on the second surface; and a redistribution layer formed on the second surface of the mold body excluding the sensing area and in which a plurality of fan-out terminal pads for electrically connecting the sensor to the outside are arranged.

Furthermore, the sensor according to another embodiment of the present invention includes: a mold body having a first surface and a second surface which are flat on a lower portion and an upper portion of the mold body, respectively; a light emitting device molded inside the mold body to expose a bonding pad on the second surface; a light driving IC molded to be spaced apart from the light emitting device inside the mold body to expose the bonding pad on the second surface; a sensor molded at a distance from the light driving IC inside the mold body to expose the sensing area that senses light on the second surface; and a redistribution layer formed on the second surface of the mold body with the exception of the sensing area and including a plurality of terminal pads for electrically connecting the sensor, light emitting device, and light driving IC to the outside while interconnecting the sensor, light emitting device, and light driving IC.

The sensor according to an embodiment of the present invention further includes a controller PCB having a light passing window forming a reception path of the reflected light to receive the reflected light reflected from the object to the sensing area, and the sensor may be mounted on the lower surface of the controller PCB using solder bumps provided on the plurality of terminal pads.

The sensor according to an embodiment of the present invention may further include a cover positioned above the redistribution layer to seal the sensing area of the sensor.

This invention provides an O-SIP that includes a light emitting device and a light driving IC in the package using an optical FOWLP without using a conductive via to solve the problems present in the optical package manufactured using a conductive via in the FOWLP. The O-SIP may include an optical module that generates an optical signal.

The light emitting device and the light driving IC may be molded in a package, and an exposed surface of an optical IC having a terminal pad and a light entrance/exit part may be molded to face a redistribution layer (RDL). The RDL may be arranged on the mold, and an external connection terminal pad may be arranged on the RDL. A microlens, an optical system, a metasurface, or a layer having various patterns may be manufactured at a wafer level through an additional micro electro mechanical system (MEMS) or imprint process on the RDL.

In the related art, glass is used as a lens to refract light to sharpen an image or to amplify the image. However, a metasurface serving as a metalens may have a structure such as a nano-sized column or pin, thereby concentrating light without image distortion.

When packaging is performed in the above-described FOWLP form, for example, when a surface mount technology (SMT) is applied to a controller PCB in which a control unit is formed, the light entrance/exit part may be blocked due to the controller PCB. To solve this problem, according to the present invention, it is possible to solve the problem by manufacturing a light entrance/exit part by making a through hole or using a transparent material in the controller PCB. Thereafter, optical components such as necessary lenses and optical fibers may be assembled on the controller PCB.

Furthermore, in the present invention, metal structures for heat dissipation may be arranged on the lower portions of the light emitting device and the light driving IC, which are molded for heat dissipation of the light emitting device and the light driving IC. The surfaces of the metal structures are opened to expose the metal structures on the opposite surface of the package facing the RDL of the FOWLP, and the exposed surfaces of the metal structures are connected to heat dissipation structures such as a heat sink or a thermal interface material (TIM) to form a heat dissipation path.

In addition, in order to electrically connect the lower portions of the light emitting device and the light driving IC, the metal structures may be connected to the RDL located on the upper surface of the FOWLP. In this case, a metal may be deposited on the entire lower surface of the FOWLP at a wafer level to form a metal connection layer, and then the metal structure and the RDL of the FOWLP may be connected through the conductive via or the metal structures may be electrically connected therebetween by the metal connection layer.

Moreover, in the O-SIP of the present invention, the light emitting device is a single optical device or an integrated circuit in which multiple optical devices are integrated in the form of an array, and may serve to convert electrical signals into optical signals. For example, the light emitting device may employ a vertical-cavity surface-emitting laser (VCSEL) or a laser diode (LD).

In addition, a driving circuit for driving the light emitting device may be used as the light driving IC.

The present invention provides an O-SIP in which a plurality of light emitting devices and light driving ICs are located inside a package formed in an SIP form without using a separate substrate, and an optical path between the light emitting devices and the outside of the SIP is formed. The O-SIP of the present invention enables smaller and more inexpensive optical modules for a light emitting unit as the substrate usage is excluded.

In the present invention, a slim O-SIP may be implemented by packaging the light emitting device and the light driving IC by using a fan-out technology of pulling out input/output (I/O) terminals thereby increasing the I/O terminals, that is, a fan-out wafer level package (FOWLP) technology, while the light driving IC (such as a chip) operating according to the light emitting device is integrated together with the light emitting device, without wire-bonding, by using a flip chip package technology, and simultaneously, while the devices are integrated without using a substrate.

In order to fix a chip (die) without using a substrate such as a PCB, the O-SIP, which is a kind of SIP technology, may miniaturize and slim at a level of 1/16 or so compared to a conventional package by packaging using an encapsulation material such as an epoxy mold compound (EMC) and reduce costs.

The optical module obtained by combining the O-SIP according to the present invention with the controller PCB not only forms a slim structure as a whole, but also achieve heat dissipation through a heat sink or a body housing of a terminal or the like made of metal through a heat dissipation metal structure attached to the rear surface of the O-SIP instead of the controller PCB, thereby preventing performance degradation.

### ADVANTAGEOUS EFFECTS

As mentioned above, this invention may implement an ultra-thin package by using a semiconductor package method based on a fan-out wafer level package (FOWLP) method instead of a package using a PCB of a thick layer, so that the light emitting unit and the light receiving unit may be packaged into one or two system-in-packages (SIP) at a wafer level.

In addition, the present invention may have a SIP that may minimize the height from the sensor imaging surface to the floor of the light receiving unit.

Moreover, in this invention, even if the SIP for the light emitting unit is mounted like a ToF sensor for the light receiving unit on the rear side of the controller PCB, it is possible to mount the SIP without covering the light entrance/exit part of the light source (e.g., VCSEL) of the light emitting unit due to the PCB hole tolerance.

In the present invention, a light source (e.g., VCSEL) of a light emitting unit and a light driving IC are integrated into a system-in-package (SIP) for a light emitting unit to reduce inductance between the light source (e.g., VCSEL) and the light driving IC, thereby increasing the resolution of the ToF sensor by a gain of rise/fall time when light in the form of a square wave (pulse) is generated.

In addition, in the present invention, effective heat dissipation may be achieved through a housing of a main body in which a light emitting unit and a light receiving unit implemented in a system-in-package (SIP) form are mounted on a lower portion of a controller PCB, so that heat dissipation of the light emitting unit and the light receiving unit may be effectively dissipated through the housing of the main body made of metal without being disturbed by the controller PCB.

In the present invention, the light emitting unit and the light receiving unit implemented in the form of a SIP under the controller PCB may be mounted in a flip-chip type, thereby providing a slim package structure and increasing productivity.

In addition, in this invention, the lens unit may be mounted on the upper part of the controller PCB, and the light emitting unit and the light receiving unit implemented in the form of a SIP may be mounted on the lower part thereof. As a result, the devices may be mounted on both the upper surface and the lower surface of the controller PCB, thereby reducing the area of the PCB.

Moreover, in the present invention, various lenses required for the light emitting unit and the light receiving unit may be accommodated in one lens housing, thereby simplifying the structure.

In the present invention, a sensing area of the sensor may be safely protected by a primary sealing of the sensing area of the sensor by a filter and a secondary sealing of an outer circumference of the sensor in contact with a controller PCB.

In general, the thickness of the sensor module is largely determined in two ways: the first is the distance from the sensing surface of the sensor to the lens, and the second is the distance from the sensing surface of the sensor to the bottom of the housing.

When the optical system is used as it is, the distance of the lens from the sensor surface is the same as that of the conventional art, but the distance from the housing to the sensor surface in the conventional art was high by reflecting the height of the PCB and the FOWLP, but in this invention, a sensor die is directly bonded to the housing, and thus, it is possible to manufacture a sensor module with a much lower height compared to the conventional art.

The present invention may solve the problem of a cost increase, the inefficiency of arrangement of a terminal pad, and the deterioration of the heat dissipation performance, which are due to the use of an existing conductive via pointed to as the disadvantage of the FOWLP using the existing conductive via.

In addition, in this invention, arrangement of the Fan-in and Fan-out terminal pads may be used simultaneously, thereby efficiently arranging terminal pads, and as a result, the package size may be reduced when the terminal pad may be further integrated, thereby achieving miniaturization of products and reduction of a process cost.

Furthermore, the present invention may solve the problem of a cost increase, the inefficiency of arrangement of a terminal pad, and the deterioration of the heat dissipation performance, which are due to the use of an existing conductive via pointed to as the disadvantage of the FOWLP using the existing conductive via.

In addition, in this invention, arrangement of the Fan-in and Fan-out terminal pads may be used simultaneously, thereby efficiently arranging terminal pads, and as a result, the package size may be reduced when the terminal pad may be further integrated, thereby achieving miniaturization of products and reduction of a process cost.

Moreover, in this invention, it is possible to manufacture a package that exhibits superior heat dissipation performance than an optical package product through a FOWLP using a conventional CoB method and an existing conductive via.

In addition, in the case of using the O-SIP structure of this invention, an optical module with the minimum thickness may be manufactured for each application as described in the following examples.

The optical module obtained by combining the O-SIP according to the present invention with the controller PCB not only forms a slim structure as a whole, but also achieve heat dissipation through a heat sink or a body housing made of metal through a heat dissipation metal structure attached to the rear surface of the O-SIP instead of the controller PCB, thereby preventing performance degradation.

In addition, in the present invention, a microlens, an optical system, a metasurface, or a layer having various patterns may be manufactured at a wafer level through an additional micro electro mechanical system (MEMS) or imprint process on the RDL, to thereby realize an increase in productivity and a slim structure.

### BRIEF DESCRIPTION OF THE DRAWINGS

FIG. 1 is a cross-sectional view of a time of flight (ToF) camera including a ToF sensor using an optical system-in-package (O-SIP) according to the present invention.
FIG. 2 is a cross-sectional view showing an O-SIP for a light emitting unit according to the present invention.
FIG. 3 is a cross-sectional view illustrating an O-SIP for a Fan-In type light receiving unit according to a first embodiment of the present invention.
FIG. 4 is a cross-sectional view illustrating an O-SIP for a Fan-Out type light receiving unit according to a second embodiment of the present invention.
FIG. 5 is a cross-sectional view illustrating an embodiment in which an optical O-SIP for a light emitting unit and an O-SIP for a light receiving unit are integrated into a single Fan-Out type O-SIP according to a third embodiment of the present invention.

### BEST MODE FOR CARRYING OUT THE INVENTION

Hereinafter, embodiments of the present invention will be described in detail with reference to the accompanying drawings.

The sizes and shapes of the components shown in the drawings may be exaggerated for clarity and convenience. In addition, terms defined in consideration of the configuration and operation of the present invention may vary depending on the intention or custom of the user, the operator, and the like. Definitions of these terms should be based on the content of this specification.

A time of flight (ToF) sensor may emit an optical signal to an object (a target object) based on ToF technology, sense an optical signal reflected from the object, and sense a distance between the ToF sensor and the object.

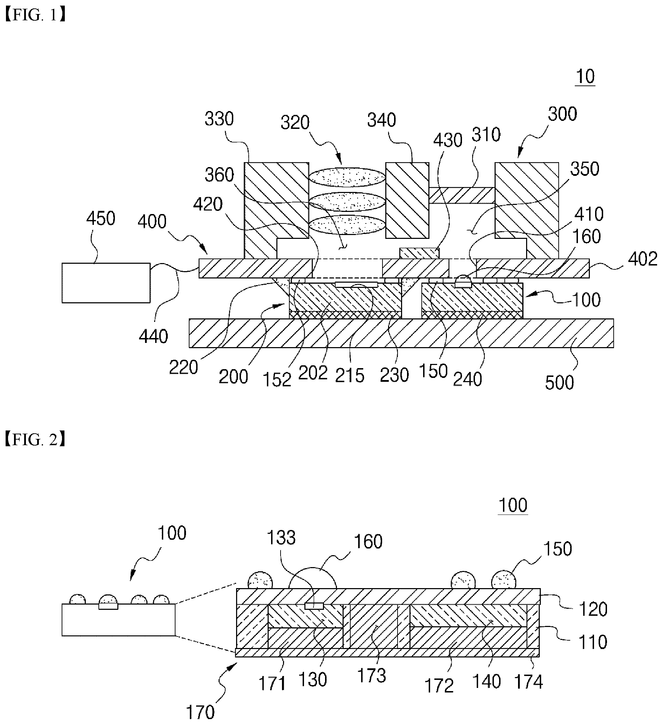

Hereinafter, a ToF camera according to an embodiment of the present invention will be described with reference to FIGS. 1 and 2.

The ToF camera 10 according to an embodiment of the present invention may include a light emitting unit 100, a light receiving unit 200, a lens unit 300, and a control unit 400.

As described later in FIG. 2, the light emitting unit 100 may be implemented as an optical system-in-package (O-SIP) in which a light emitting device 130 and a light driving IC 140 are included in a mold body 110, a redistribution layer 120 is formed on the second surface 114 of the mold body 110, and a heat dissipation device 170 is stacked on a first surface 112 of the mold body 110.

The light emitting unit 100 may be a unit that generates an optical signal and then outputs the generated optical signal to an object. To this end, the light emitting unit 100 may include a configuration capable of generating light, such as the light emitting device 130, and a configuration capable of modulating light. The optical signal may be in the form of a pulse wave or a continuous wave. The continuous wave may be in the form of a sinusoidal wave or a squared wave.

In addition, the light emitting unit 100 may generate light pulses at a constant period. The light emitting unit 100 may generate a light pulse having a predetermined pulse width (tpulse) at a predetermined pulse repetition period (tmodulation).

Moreover, the light emitting unit 100 may output optical signals to various irradiation regions. The light emitting unit 100 may drive a light emitting device array (IC chip) for each region to output optical signals to various irradiation regions. The light emitting unit 100 may include a light emitting device array for changing an irradiation region according to a control signal.

The light emitting device 130 may emit an optical signal. The light emitting device 130 may (turn on) or may not (turn off) emit an optical signal under the control of the light driving IC 140. For example, the optical signal may have the form of a squared wave (pulse) or a sinusoidal wave. The optical signal may be a signal in a band not sensed by a user, and may be a laser, a laser pulse, an infrared signal, a microwave, a light wave, an ultrasonic wave, and the like, but is not limited to the above-described examples.

For example, the light emitting device 130 may include a laser light source, a light emitting diode (LED), a laser diode (LD), an organic LED (OLED), an edge emitter laser, a vertical-cavity surface-emitting laser (VCSEL), a distributed feedback laser, etc.

The light receiving unit 200 may sense light reflected from an object. The light receiver 200 may sense an optical signal reflected from the object. In this case, the sensed optical signal may be a reflection, by an object, of an optical signal output from the light emitting unit 100. The light receiving unit 200 may include a filter 322 and a sensor 202 to sense an optical signal.

The optical signal reflected from the object may pass through a lens assembly 320. The optical axis of the lens assembly 320 may be aligned with the optical axis of the sensor 202.

The lens assembly 320 is composed of a lens combination such as a plurality of convex lenses and a plurality of concave lenses, and serves to make the light passing through the lens assembly 320 formed into a focused image on an imaging surface such as an image sensor.

The filter 322 may be arranged between the lens assembly 320 and the sensor 202. The filter 322 may be arranged on an optical path between the object and the sensor 202. The filter 322 may filter light having a predetermined wavelength range. The filter 322 may transmit a specific wavelength band of light. Moreover, the filter 322 may pass light of a specific wavelength.

For example, the filter 322 may pass light in a wavelength band of an optical signal output from the light emitting unit 100. The filter 322 may pass light in an infrared band and block light other than the infrared (IR) band. In addition, the filter 322 may pass visible light and block light having wavelengths other than visible light.

The filter 322 may be made of glass and may be a cover for sealing a sensing area of a sensor to be simply protected from foreign substances.

The sensor 202 may sense light. The sensor 202 may receive an optical signal. Accordingly, the sensor 202 may be an image sensor that senses an optical signal.

The sensor 202 may sense an optical signal and output the optical signal as an electrical signal. The sensor 202 may sense light having a wavelength corresponding to a wavelength of light output from the light emitting device 130. The sensor 202 may sense light in an infrared band or light in a visible light band.

The sensor 202 may include a pixel array for converting light passing through the lens assembly 320 into a corresponding electrical signal, a driving circuit for driving a plurality of pixels included in the pixel array, and a readout circuit for reading an analog pixel signal of each pixel.

The readout circuit may compare an analog pixel signal with a reference signal to generate a digital pixel signal (or an image signal) through analog-to-digital conversion. Here, the digital pixel signal of each pixel included in the pixel array constitutes an image signal, and the image signal may be defined as an image frame as the image signal is transmitted in a frame unit. That is, the image sensor may output a plurality of image frames.

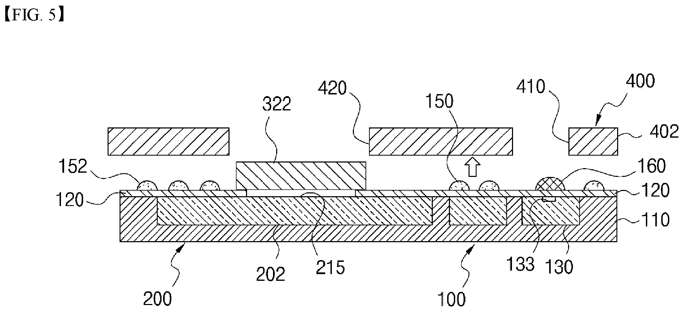

In this case, as shown in FIGS. 1 and 5, the light receiving unit 200 may be mounted on the lower surface of the controller PCB 402 constituting the control unit 400 and may be arranged side by side with the light emitting unit 100 at intervals. That is, the light receiving unit 200 may be arranged next to the light emitting unit 100. The light receiving unit 200 may be arranged in the same direction as the light emitting unit 100.

The lens unit 300 may include a lens 310 for the light emitting unit and a lens assembly 320 for the light receiving unit.

Each of the lens 310 for the light emitting unit and the lens assembly 320 for the light receiving unit may include at least one lens. The lens 310 for the light emitting unit and the lens assembly 320 for the light receiving unit may include a plurality of lenses, and may be supported by one lens housing 330.

The lens housing 330 has a partition 340 arranged at the center to partition a first space 350 in which the lens 310 for the light emitting unit is accommodated and a second space 360 in which the lens assembly 320 for the light receiving unit is accommodated.

The lens 310 for the light emitting unit includes a diffuser that spreads light so that the light emitting device 130 itself may take a larger light emitting area than the light emitting area of the light emitting device 130. The optical lens 160 formed on the upper portion of the RDL 120 serves to collect light so that the light emitted from the light emitting device 130 may enter the area of the diffuser.

The plurality of lenses may be fixed at intervals. The plurality of lenses may be moved together by a driving member embedded in the lens housing 330. Accordingly, even if the plurality of lenses are moved by the driving member, the spacing between the lenses may be maintained.

The lens assembly 320 may collect an optical signal reflected from an object. The optical signal may be incident on the lens assembly 320 and may be provided to the pixels PX of the sensor 202 of the light receiving unit 200 serving as a ToF sensor through the lens assembly 320. For example, the lens assembly 320 may be an optical system including a plurality of lenses.

The light receiving unit 200 may also be referred to as a ToF sensor (chip), a complementary metal-oxide semiconductor (CMOS) image sensor (CIS) (chip), a charge-coupled device (CCD) image sensor (chip), a depth sensor (chip), or the like.

The light receiving unit 200 may include a pixel array including pixels PX. The pixel PX may also be referred to as a ToF pixel and may convert an optical signal reflected from an object into an electrical signal.

Due to the distance between the light receiving unit 200 and the object, a second optical signal incident on the pixel array of the sensor 202 may be delayed than a first optical signal output by the light emitting device 130 of the light emitting unit 100. For example, there may be a parallax or phase difference between the first and second optical signals, and the electrical signal converted by the pixel PX may represent a parallax or phase difference. The control unit 400 may calculate a distance between the light receiving unit 200 and the object based on the first and second optical signals.

The control unit 400 may control driving of at least one of the light emitting unit 100 and the light receiving unit 200. In an embodiment, the control unit 400 may generate a control signal and supply the generated control signal to the light driving IC 140 of the light emitting unit 100 to control driving of the light emitting device 130.

In another embodiment, the control unit 400 may generate a control signal and control an optical path change of an optical signal through the generated control signal.

The control unit 400 may be included in the ToF camera 10. For example, the control unit 400 may be implemented in a form coupled to the controller PCB 402 of the ToF camera 10.

The control unit 400 may control the light emitting unit 100, the light receiving unit 200, and the lens unit 300.

The control unit 400 may synchronize the light emitting unit 100 and the light receiving unit 200 with each other, and may transmit control signals for controlling the light emitting unit 100, the light receiving unit 200, and the lens unit 300 to the light emitting unit 100, the light receiving unit 200, and the lens unit 300 based on the same clock signal. To this end, the control unit 400 may include a clock generator that generates a clock signal.

In addition, the control unit 400 includes a memory device and a signal processing device, and may generate an image based on the electric signal generated by the light receiving unit 200 by the signal processing device. The control unit 400 may generate a subframe image from an electric signal generated every phase pulse period. Furthermore, the control unit 400 may generate one frame image from a plurality of sub-frame images generated during a frame pulse period.

Moreover, the control unit 400 may generate a single high-resolution image through a plurality of sub-frame images or a plurality of frame images.

The lens housing 330 that forms the lens unit 300 and accommodates the lens 310 for the light emitting unit and the lens assembly 320 for the light receiving unit are mounted on the upper surface of the controller PCB 402 of the control unit 400, and the light emitting unit 100 including an O-SIP for the light emitting unit and the light receiving unit 200 including an O-SIP for the light receiving unit are mounted on the lower surface of the controller PCB 402 of the control unit 400.

In this case, the O-SIP for the light receiving unit is mounted on the lower surface of the controller PCB 402 using terminal pads 152 made of solder balls, and then epoxy is applied to the outer circumference of the sensor 202 bonded to the controller PCB 402 to form a sealing part 220.

A memory device for storing an electrical signal converted from an optical signal reflected from an object and incident on the sensor 202 of the light receiving unit 200, and various passive devices may be mounted on the controller PCB 402.

Hereinafter, an O-SIP according to the present invention constituting the light emitting unit 100 will be described with reference to FIG. 2.

The O-SIP according to the present invention includes a light emitting device 130 and a light driving IC 140 inside a mold body 110, and the mold body 110 has a first surface (or a lower surface) 112 and a second surface (or an upper surface) 114 that face each other and are flat. A redistribution layer (RDL) 120 including a plurality of terminal pads 150 for external connection of the package may be formed on the second surface (or the upper surface) 114 of the mold body 110.

The O-SIP according to the present invention may be implemented into a slim O-SIP while completely solving a height tolerance due to a wiring between devices by packaging the light emitting device 130 and the light driving IC 140 by using a fan-out technology of pulling out input/output (I/O) terminals thereby increasing the I/O terminals, that is, a fan-out wafer level package (FOWLP) technology, while the photonic IC 130 and the electronic IC 140 are integrated, without wire-bonding, by using a flip chip package technology, and simultaneously, while the devices are integrated without using a substrate. The O-SIP may miniaturize and slim at a level of 1/16 or so compared to a package of using a conventional PCB and reduce costs.

In the case of the O-SIP, the light emitting device 130 and the light driving IC 140 are integrated in a flip chip form without using a substrate such as a PCB as a kind of System-In-Package (SIP) technology, and, for example, the mold body 110 is formed by packaging the light emitting device 130 and the light driving IC 140 by using an encapsulation material such as an epoxy mold compound (EMC) for fixing a chip (die).

As a result, the mold body 110 serves to safely protect, from impact, an optical module, which is packaged after being integrated. The O-SIP 100 including the light emitting device 130 and the light driving IC 140 in the mold body 110 may constitute an optical module.

In addition, the O-SIP may be obtained as a semiconductor package type, by performing a manufacturing process using a semiconductor process in units of wafers, then integrally forming a redistribution layer 120 including a plurality of terminal pads 150 on the second surface 114 of the package, and performing a dicing process that individually separates the O-SIP.

The light emitting device 130 and the light driving IC unit 140 are molded in a package, and terminal pads 150 each on which a solder ball for electrical connection is mounted, are arranged above the second surface 114 of the mold body 110, and the light output/input part 133 is arranged on the second surface 114 of the mold body 110. The light emitting device 130 is an integrated circuit (IC) that performs optical processing, and serves to convert an electrical signal into an optical signal.

The light emitting device 130 may include a laser light source, a light emitting diode (LED), a laser diode (LD), an organic LED (OLED), an edge emitter laser, a vertical-cavity surface-emitting laser (VCSEL), a distributed feedback laser, etc.

The light driving IC 140 includes a driving circuit for driving the light emitting device 130.

In this case, various materials including a semiconductor material such as GaAs, InGaAs, Si, SiN, Glass, Quartz, and SiON may be used as the device for the light emitting device 130, and various semiconductor materials such as Si, SiC, SiGe, and the like may be used as the device for the light driving IC 140. In order to mold the light emitting device 130 and the light driving IC 140, an encapsulation material such as an epoxy mold compound (EMC) and an epoxy resin may be used, and in a molding operation, several cells may be molded at a time at a wafer and panel level.

A redistribution layer 120 may be formed on the second surface (the upper surface) 114 of the mold body 110 formed by the encapsulation material, and the redistribution layer 120 may include terminal pads 150 for external connection of the package.

In order to form the insulating layer for the redistribution layer 120, various materials including polyimide (PI), poly (methylmethacrylate) (PMMA), benzocyclobutene (BCB), silicon oxide (SiO₂), acryl, and epoxy groups may be used, and a photo-lithography process may be used to form a wiring layer pattern.

In this case, the material of a wiring layer may serve as a photoresist (PR) capable of being developed, and the wiring layer may be etched after a PR coating is additionally performed. A process of depositing a metal is undergone after forming an insulating layer, and the metal used for the redistribution layer 120 may include various metal materials such as Cu, Al, Au, and Ag, or a compound thereof.

The redistribution layer 120 shown in FIG. 2 is connected in two stages: an interconnection between the light emitting device 130 and the light driving IC 140 from the bonding pad of each of the light emitting device 130 and the light driving IC 140 exposed to the second surface 114 of the mold body 110; and an interconnection between the bonding pad and a plurality of terminal pads 150 at the top of the package by using first and second connection wirings made of metal formed on first and second insulating layers to form the plurality of terminal pads 150 in the form of fan-out for connection with the outside of the O-SIP.

The external connection terminal pads 150 formed on the redistribution layer 120 may be manufactured by directly exposing a metal surface of the redistribution layer 120 to the outside, such as a land grid array (LGA) type, or mounting solder balls on an upper portion of the package, such as a ball grid array (BGA) type, as shown in FIG. 2.

In this case, the first and second insulating layers may be made of transparent materials so that the RDL 120 receives the optical signal generated from the light emitting device 130 because the light emitting device 130 is made of a laser diode for generating an optical signal.

In addition, when the first and second insulating layers are made of opaque material, the RDL 120 may have an opening 136, formed in part or in whole, through which the optical signal generated from the light emitting device 130 can pass.

Furthermore, as illustrated in FIG. 2, the redistribution layer 120 may further include an optical lens 160 for changing (controlling) a path of light L generated from the light emitting device 130 even when the first and second insulating layers include a transparent material.

The optical lens 160 may be configured as, for example, a collimating lens in which light L generated from the light emitting device 130 is not dispersed and creates a path close to parallel.

In the O-SIP according to an embodiment of the present invention, the RDL 120 is formed on the second surface 114 of the mold body 110, and the heat dissipation device 170 is provided on the first surface 112 of the mold body 110.

The heat dissipation device 170 may include first and second metal structures 171 and 172 for heat dissipation on the lower portions of the light emitting device 130 and the light driving IC 140, respectively.

The sizes of the first and second metal structures 171 and 172 may be greater or less than those of the light emitting device 130 and the light driving IC 140, respectively.

As a method of forming the first and second metal structures 171 and 172, metal pieces may be attached to lower portions of the light emitting device 130 and the light driving IC 140, respectively, and then a FOWLP process may be performed in a state in which the metal pieces are attached to the light emitting device 130 and the light driving IC 140. In this case, a variety of adhesives may be used to attach the light emitting device IC 130 and the light driving IC 140 to the metal pieces, which may use silver epoxy or epoxy, EMC, or carbon nanotube (CNT) compound. For the best heat dissipation performance and electrical conductivity, a conductive material such as silver epoxy may be used. In the present invention, a conductive material may also be used to apply an electrical signal to the lower surfaces of the light emitting device 130 and the light driving IC 140.

In addition, when connecting the light emitting device 130 and the light driving IC 140 with the redistribution layer 120, a conductive structure in the form of a via should be formed in a FOWLP. In the present invention, a third metal structure 173 is molded together with other light emitting device 130 and light driving IC 140 during a FOWLP by using a PCB including via or a Cu piece. Subsequently, after grinding and flattening the third metal structure 173 so that the upper and lower metals of the third metal structure 173 for via are exposed, a metal connection layer 174 may be formed by depositing a metal under the light emitting device 130 and the light driving IC 140, and a redistribution layer 120 may be formed on the light emitting device 130 and the light driving IC 140.

As a result, the first and second metal structures 171 and 172 may be electrically connected and wired to the redistribution layer 120 through the third metal structure 173 for via. In this case, a metal may be deposited on the bottom of the wafer at a wafer level to be connected without a pattern, or a wiring layer may be formed on the opposite surface of the redistribution layer 120 of the FOWLP wafer so as to be connected to each other as a double-sided wiring layer.

In the present invention, the redistribution layer 120 may be electrically connected to the metal connection layer 174 through the third metal structure 173 for via to use the metal connection layer 174 as a ground, and the heat of the redistribution layer 120 may be easily dissipated to the first surface (or the lower surface) 112 through the third metal structure 173 for via.

The O-SIP according to the present invention may be electrically connected to the redistribution layer 120 through the third metal structure 173 for via of wide width, thereby minimizing inductance.

Meanwhile, instead of forming the first and second metal structures 171 and 172 for heat dissipation, the O-SIP according to the present invention may be flattened so that the lower surfaces of the light emitting device 130 and the light driving IC 140 are exposed by grinding the first surface (or the lower surface) 112 of the mold body 110. As described above, when the lower surfaces of the light emitting device 130 and the light driving IC 140 are exposed, heat dissipation may be directly performed.

The O-SIP may be mounted on the first surface (lower surface) of the controller PCB 402 by using solder balls of the terminal pads 150, and in this case, a Surface Mount Technology (SMT) method may be used. In this case, various electronic components required to control the transmission of an optical signal as an optical module may be mounted on the first surface (lower surface) and/or the second surface (upper surface) of the controller PCB 402.

First and second light passing windows 410 and 420 are formed in the controller PCB 402 by processing through holes in the light entrance/exit part 133 of the light emitting device 130 and on the upper part of the sensing area 215 of the sensor 202, respectively.

Accordingly, the optical signal generated from the light emitting device 130 is transmitted through the first light passing window 410, and the reflected light reflected and received from the target object is incident on the sensing area 215 of the sensor 202 through the second light passing window 420, to be captured.

In this case, a resistance component 430 may be arranged on the upper surface of the controller PCB 402 between the first light passing window 410 and the second light passing window 420. The resistance component 430 may have a rectangular parallelepiped shape, and as a result, may serve to prevent mixing between the diverging light emitted to an object through the first light passing window 410 and the reflected light reflected from the object and incident on the second light passing window 420.

The controller PCB 402 may be made of a rigid PCB or a flexible thin film PCB (FPCB), and various devices may be mounted on both surfaces of the controller PCB 402.

Furthermore, the controller PCB 402 may be connected to a main board embedded in the main body of a terminal or the like through a connection FPCB 440 with a connector 450 attached to the front end thereof.

In this invention, thermal interface materials (TIM) 230 and 240 are attached to the lower surface of the metal connection layer 174 for the heat dissipation of the O-SIP for the light emitting unit, and the lower surface of the sensor 202 of the O-SIP for the light receiving unit, respectively, so that a heat dissipation path to the outside through a metal housing 500 of the terminal body may be efficiently formed.

This heat dissipation structure minimizes the transfer of heat generated from the O-SIP for the light emitting unit and the O-SIP for the light receiving unit to the controller PCB 402 to the controller PCB 402, and may form a heat dissipation path to the outside through the metal housing 500 of the terminal body, greatly reducing thermal resistance.

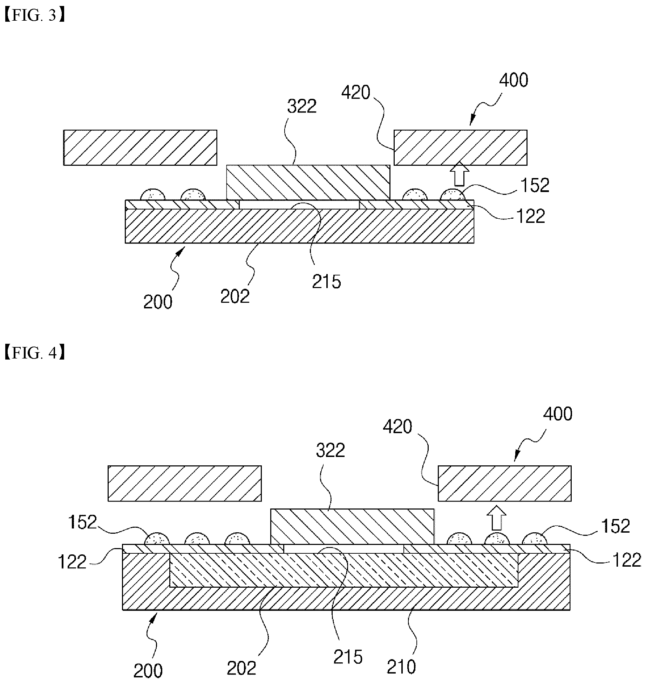

FIG. 3 is a cross-sectional view illustrating an O-SIP for a fan-in type light receiving unit according to a first embodiment of the present invention, and FIG. 4 is a cross-sectional view illustrating an O-SIP for a fan-out type light receiving unit according to a second embodiment of the present invention.

First, referring to FIG. 3, a fan-in type O-SIP for light receiving units according to the first embodiment of the present invention has a redistribution layer 122 formed at a remaining portion except for the sensing area 215 on the top surface of a sensor 202, which may include an image sensor chip (IC), for example, and the plurality of terminal pads 152 to which solder balls are attached are arranged on the top of the redistribution layer 122.

In this case, a filter 322 is mounted on the upper portion of the redistribution layer 122 including the sensing area 215 to protect the sensing area 215.

Since the sensing area 215 located at the center of the upper surface of the sensor 202 is an area in which reflected light reflected from an object (e.g., target object) is incident to be captured, it is required to block contamination due to accumulation of dust or the like.

To this end, in the present invention, the filter 322 is installed on the upper portion of the redistribution layer 122 to primarily seal the sensing area 215, and the sensor 202 on which the filter 322 is mounted is surface-mounted on the rear surface of the controller PCB 402 so that the filter 322 is matched to the second light passing window 420 of the controller PCB 402. Then, a secondary sealing part 220 is formed by applying epoxy on the outer circumferential portion of the sensor 202 bonded to the controller PCB 402.

In the O-SIP for a light receiving unit according to the first embodiment of the present invention, the plurality of terminal pads 152 arranged on the upper portion of the redistribution layer 122 are arranged in a Fan-In type only on the upper surface of the sensor 202.

Referring to FIG. 4, in the Fan-Out type O-SIP for the light receiving unit according to the second embodiment of the present invention, the sensor 202, which may include an image sensor chip (IC), is molded inside the mold body 210. A redistribution layer 122 is formed at a remaining portion except for the sensing area 215 on the upper surfaces of the mold body 210 and the sensor 202. The plurality of terminal pads 152 to which solder balls are attached are arranged on the top of the redistribution layer 122.

A filter 322 is mounted on the upper portion of the redistribution layer 122 including the sensing area 215 to protect the sensing area 215.

In the fan-out type O-SIP for the light receiving unit according to the second embodiment of the present invention, packaging is performed by using a fan-out technology of pulling out input/output (I/O) terminals thereby increasing the I/O terminals, that is, a fan-out wafer level package (FOWLP) technology, while devices are integrated without wire-bonding, by using a flip chip package technology, and simultaneously, while the devices are integrated without using a substrate. The first embodiment differs from the first embodiment in that the plurality of terminal pads 152 are arranged, in a fan-out type, on the upper surface of the redistribution layer 122 formed on the upper surfaces of the sensor 202 and the mold body 210.

FIG. 5 is a cross-sectional view illustrating an embodiment in which an optical O-SIP for a light emitting unit and an O-SIP for a light receiving unit are integrated into a single Fan-Out type O-SIP according to a third embodiment of the present invention.

Referring to FIG. 5, the third embodiment differs from the first and second embodiments in that the light emitting unit 100 and the light receiving unit 200 are molded inside one mold body 110 in the O-SIP according to the third embodiment of the present invention.

The O-SIP according to the third embodiment is packaged using a FOWLP method. The light emitting device 130, the light driving IC 140, and the sensor 202 are molded inside the mold body 110. The redistribution layer 120 is formed at a remaining portion except for the sensing area 215, on the upper surfaces of the mold body 110, the light emitting device 130, the light driving IC 140, and the sensor 202. The plurality of terminal pads 150 and 152 to which solder balls are attached are arranged on the top of the redistribution layer 122.

The optical lens 160 may be formed on the redistribution layer 120 located on the light entrance/exit part 133 of the light emitting device 130.

In this case, a filter 322 is mounted on the upper portion of the redistribution layer 120 including the sensing area 215 to protect the sensing area 215.

In addition, the optical lens 160 of the light emitting device 130 is matched to the first light passing window 410 of the controller PCB 402, and the sensor 202 on which the filter 322 is mounted is surface-mounted so that the filter 322 is matched to the second light passing window 420 of the controller PCB 402.

Then, the sealing part 220 is formed by applying epoxy on the outer circumferential portion of the integrated O-SIP bonded to the controller PCB 402.

In the integrated O-SIP according to the third embodiment of the present invention, packaging is performed by using a fan-out type FOWLP technology of pulling out input/output (I/O) terminals thereby increasing the I/O terminals, while devices are integrated without wire-bonding, by using a flip chip package technology, and simultaneously, while the devices are integrated without using a substrate. A plurality of terminal pads 150 and 152 are fan-out type and are arranged on the redistribution layer 120 formed on the upper surfaces of the light driving IC 140, the sensor 202, and the mold body 110.

A thermal interface material (TIM) in the form of a tape may be attached to a lower surface of the integrated O-SIP to form a heat dissipation path to the outside through the metal housing 500 of the terminal body.

As mentioned above, this invention may implement an ultra-thin package by using a semiconductor package method based on a FOWLP method instead of a package using a PCB of a thick layer, so that the light emitting unit 100 and the light receiving unit 200 may be packaged in the form of one or two system-in-packages (SIP) at a wafer level.

In addition, the present invention may have a SIP that may minimize the height from the sensor imaging surface to the floor of the light receiving unit 200.

Moreover, in this invention, although the light emitting unit 100 implemented in the form of a SIP is mounted like the sensor 202 of the light receiving unit 200 behind the controller PCB 400, it is possible to mount the light emitting unit 100 without covering the light entrance/exit part 133 of the light emitting device 130 of the light emitting unit 100 due to a PCB hole tolerance.

In the present invention, the light emitting device 130 and the light driving IC 140 of the light emitting unit 100 may be integrated in the form of a SIP encapsulated inside the mold body 110. Accordingly, when the inductance between the light emitting device 130 and the light driving IC 140 is reduced and light in the form of a square wave (pulse) is generated, a ToF sensor resolution may be increased by a gain of rise/fall time.

In addition, in this invention, as the light emitting unit 100 and the light receiving unit 200, which are each implemented in the form of a SIP, are mounted under the controller PCB 400, the heat dissipation of the light emitting unit 100 and the light receiving unit 200 may be effectively achieved through the main body housing 500 made of metal without being disturbed by the controller PCB 400.

In the present invention, the light emitting unit 100 and the light receiving unit 200 implemented in the form of a SIP under the controller PCB 400 may be mounted in a flip-chip type, thereby providing a slim package structure and increasing productivity.

In addition, in this invention, the lens unit 300 may be mounted on the upper part of the controller PCB 400, and the light emitting unit 100 and the light receiving unit 200 implemented in the form of a SIP may be mounted on the lower part thereof. As a result, the devices may be mounted on both the upper surface and the lower surface of the controller PCB 400, thereby reducing the area of the PCB.

Moreover, in the present invention, various lenses required for the light emitting unit 100 and the light receiving unit 200 may be accommodated in one lens housing 300, thereby simplifying the structure.

In the present invention, the sensing area 215 of the sensor 202 may be safely protected by primary sealing of the sensing area 215 of the sensor 202 by the filter 322 and secondary sealing of the outer circumferential portion of the sensor 202 or the mold body 210 in contact with the controller PCB 400.

While the present invention has been particularly shown and described with reference to exemplary embodiments thereof, by way of illustration and example only, it is clearly understood that the present invention is not to be construed as limiting the present invention, and various changes and modifications may be made by those skilled in the art within the protective scope of the invention without departing off the spirit of the present invention.

### INDUSTRIAL APPLICABILITY

This invention may be applied to a ToF sensor and a ToF camera using same, the ToF sensor being implemented into an ultra-thin package by packaging a light emitting unit and a light receiving unit into one or two SIP at a wafer level according to a FOWLP method instead of a package using a PCB of a thick layer.

In addition, the ToF sensor may be used in various ways in augmented reality (AR), virtual reality (VR), mixed reality (MR), and mobile phones.

## Claims

1. A time of flight (ToF) camera comprising:
a light emitting unit that emits light to an object:
a light receiving unit that receives and senses the reflected light reflected from the object;
a lens unit that controls a path of the light to emit the light to the object and receive the reflected light reflected from the object by the light receiving unit; and
a control unit provided with a controller printed circuit board (PCB) on the lower surface of which the light emitting unit and the light receiving unit are mounted and on the upper surface of which the lens unit is mounted.

2. The ToF camera of claim 1, wherein the light emitting unit and the light receiving unit are formed in a single or two optical system-in-packages (O-SIP) type, and are mounted on the lower surface of the controller PCB in a flip-chip type.

3. The ToF camera of claim 1, wherein the controller PCB comprises: a first light passing window through which light emitted from the light emitting unit passes; and a second light passing window forming a reception path of the reflected light so that the reflected light is received by the light receiving unit.

4. The ToF camera of claim 1, wherein the light emitting unit comprises:
a mold body having a first surface and a second surface which are flat on a lower portion and an upper portion of the mold body, respectively;
a light emitting device molded inside the mold body to expose a bonding pad on the first surface;
a light driving integrated circuit (IC) molded to be spaced apart from the light emitting device inside the mold body to expose the bonding pad on the first surface; and
a redistribution layer (RDL) formed on the second surface of the mold body and having a plurality of fan-out terminal pads electrically connected to the outside while interconnecting the light emitting device and the light driving IC.

5. The ToF camera of claim 4, further comprising:
first and second metal structures having respective upper surfaces bonded to lower portions of the light emitting device and the light driving IC and respective lower surfaces exposed;
a third metal structure for a via that is inserted through the mold body between the light emitting device and the light driving IC, and has an upper end portion connected to the RDL and a lower end portion exposed; and
a metal connection layer that connects the RDL to the lower portions of the light emitting device and the light driving IC and has a lower surface of the metal connection layer exposed, by interconnecting the lower surfaces of the first to third metal structures.

6. The ToF camera of claim 4, further comprising an optical lens formed on the RDL and positioned above the light entrance/exit part of the light emitting device.

7. The ToF camera of claim 1, wherein the lens unit comprises a lens for the light emitting unit, a lens assembly for the light receiving unit, and a lens housing for accommodating the lens for the light emitting unit and the lens assembly for the light receiving unit therein, and the lens housing comprises a partition unit for partitioning a first space in which the lens for the light emitting unit is accommodated and a second space in which the lens assembly for the light receiving unit is accommodated.

8. The ToF camera of claim 7, wherein the lens for the light emitting unit comprises a diffuser that spreads light so that the light emitting device itself may take a larger light emitting area than the light emitting area of the light emitting device.

9. The ToF camera of claim 1, wherein the light receiving unit comprises:
a filter that is placed on an optical path between the object and a sensor and passes light in a wavelength band of an optical signal output by the light emitting unit; and
the sensor which senses the optical signal and outputs the sensed optical signal as an electrical signal and senses light of a wavelength corresponding to the wavelength of light output from a light emitting device, wherein
the filter is placed in a light passing window formed on the controller PCB to receive reflected light reflected from the object by the light receiving unit.

10. The ToF camera of claim 9, wherein the sensor comprises:
a sensor chip, with a sensing area, which senses the optical signal and outputs the sensed optical signal as an electrical signal and senses light of a wavelength corresponding to the wavelength of light output from the light emitting device;
a mold body having first and second surfaces which are flat on lower and upper portions, respectively, and surrounding the sensing area to expose the sensing area to the second surface; and
a redistribution layer formed on the second surface of the mold body excluding the sensing area and in which a plurality of terminal pads for electrically connecting the sensor to the outside are arranged.

11. The ToF camera of claim 1, wherein
the light emitting unit and the light receiving unit are formed in the form of a single O-SIP, and
the single O-SIP comprises:
a mold body having a first surface and a second surface which are flat on a lower portion and an upper portion of the mold body, respectively;
a light emitting device molded inside the mold body to expose a bonding pad on the second surface;
a light driving IC molded to be spaced apart from the light emitting device inside the mold body to expose the bonding pad on the second surface;
a sensor molded at a distance from the light driving IC inside the mold body to expose the sensing area that senses light on the second surface; and
a redistribution layer formed on the second surface of the mold body with the exception of the sensing area and including a plurality of terminal pads for electrically connecting the sensor, light emitting device, and light driving IC to the outside while interconnecting the sensor, light emitting device, and light driving IC.

12. The ToF camera of claim 1, wherein the light emitting unit and the light receiving unit are formed in the form of an O-SIP, and the light emitting unit and the light receiving unit are each installed under the package to further include a thermal interface material (TIM) for forming a heat dissipation path to a metal housing of a terminal body.

13. A sensor comprising:
a sensor that has a first surface and a second surface on lower and upper portions, respectively, to expose a sensing area that senses light on the second surface; and
a redistribution layer formed on the second surface excluding the sensing area and in which a plurality of terminal pads for electrically connecting the sensor to the outside are arranged.

14. A sensor comprising:
a mold body having a first surface and a second surface which are flat on a lower portion and an upper portion of the mold body, respectively;
a sensor molded inside the mold body to expose a sensing area that senses light on the second surface; and
a redistribution layer formed on the second surface of the mold body excluding the sensing area and in which a plurality of terminal pads for electrically connecting the sensor to the outside are arranged.

15. A sensor comprising:
a mold body having a first surface and a second surface which are flat on a lower portion and an upper portion of the mold body, respectively;
a light emitting device molded inside the mold body to expose a bonding pad on the second surface;
a light driving IC molded to be spaced apart from the light emitting device inside the mold body to expose the bonding pad on the second surface;
a sensor molded at a distance from the light driving IC inside the mold body to expose a sensing area that senses light on the second surface; and
a redistribution layer formed on the second surface of the mold body with the exception of the sensing area and including a plurality of terminal pads for electrically connecting the sensor, light emitting device, and light driving IC to the outside while interconnecting the sensor, light emitting device, and light driving IC.
